# EUROPEAN PATENT SPECIFICATION

(11) **EP 4 207 548 B1**
(45) Date of publication and mention of the grant of the patent: **26.11.2025**
(21) Application number: 22825123.7
(22) Date of filing: 21.03.2022
(51) Int. Cl.: H02J 7/00, H01M 10/42, H03K 17/687, H01M 10/44, H01M 10/48

(54) **BATTERY MANAGEMENT APPARATUS AND OPERATING METHOD THEREOF**
BATTERIEVERWALTUNGSVORRICHTUNG UND BETRIEBSVERFAHREN DAFÜR
APPAREIL DE GESTION DE BATTERIE ET SON PROCÉDÉ DE FONCTIONNEMENT

(30) Priority: 17.06.2021 KR 20210078981
(43) Date of publication of application: 05.07.2023
(73) Proprietor: LG Energy Solution, Ltd., Seoul 07335 (KR)
(72) Inventor: HWANG, Jin Woo, Daejeon 34122 (KR)
(74) Representative: Plasseraud IP
(86) International application number: PCT/KR2022/003880
(87) International publication number: WO 2022/265192

(56) References cited:
- EP-A1- 4 290 730
- EP-A2- 2 639 923
- WO-A1-2016/149440
- JP-A- 2004 349 186
- JP-A- 2010 057 290
- JP-A- 2019 075 933
- KR-A- 20140 131 174
- US-A1- 2008 150 487
- US-A1- 2016 241 057

## Description

### [Technical Field]

### TECHNICAL FIELD

The present invention relates to a battery management apparatus and an operating method thereof.

### [Background Art]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

A plurality of battery packs may be conventionally connected in parallel, but now, a plurality of battery packs may be connected in series at present through the use of a simultaneous interruption technique and a freewheeling diode. A precharge resistor is serially connected to the plurality of battery packs connected in series, such that a resistance value increases and thus a magnitude of flowing current decreases, thus increasing a precharge time.

Examples and embodiments of prior art are presented in the document KR 2014 0131174 A and EP2639923 A2.

### [Disclosure]

### [Technical Problem]

Embodiments disclosed herein aim to provide a battery management apparatus capable of reducing a precharge time of a plurality of battery packs connected in series.

Technical problems of the embodiments disclosed herein are not limited to the above-described technical problems, and other unmentioned technical problems would be clearly understood by one of ordinary skill in the art from the following description.

### [Technical Solution]

A battery management apparatus according to the invention is defined by the independent claim 1. Further embodiments of the invention are defined by the dependent claims on claim 1.

An operating method of a battery management apparatus according to the invention is defined by independent method claim 7. Further embodiments of the invention are defined by the dependent claims on claim 7.

### [Advantageous Effects]

A battery management apparatus according to embodiments disclosed herein may reduce a precharge time by generating a control signal for controlling a main relay and a precharge relay of each of a plurality of battery packs connected in series.

Moreover, various effects recognized directly or indirectly from the disclosure may be provided.

### [Description of Drawings]

FIG. 1 is a block diagram of a plurality of battery packs and a battery management apparatus, according to an embodiment disclosed herein.
FIG. 2 is a block diagram of a battery management apparatus according to an embodiment disclosed herein.
FIG. 3 illustrates a battery pack according to an embodiment disclosed herein.
FIG. 4 shows a precharge time of a plurality of battery packs according to an embodiment disclosed herein.
FIG. 5 is a flowchart of an operating method of a battery management apparatus according to an embodiment disclosed herein.
FIG. 6 is a flowchart of operations further included in an operating method of a battery management apparatus according to an embodiment disclosed herein.
FIGS. 7 and 9 are flowcharts showing in detail operation S130 in an operating method of a battery management apparatus according to an embodiment disclosed herein.

### [Mode for Invention]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

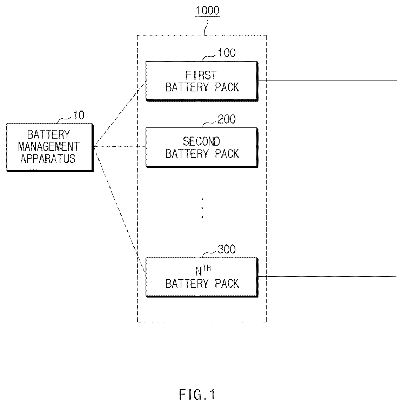

FIG. 1 is a block diagram of a plurality of battery packs and a battery management apparatus, according to an embodiment disclosed herein.

Referring to FIG. 1, a battery management apparatus 10 controls a plurality of battery packs 1000. For example, the battery management apparatus 10 controls charging and/or discharging of the plurality of battery packs 1000. The the battery management apparatus 10 geenerates a control signal for controlling a main relay (not shown) and a precharge relay (not shown) included in the plurality of battery packs 1000.

In an embodiment, the battery management apparatus 10 may be included in at least any one of battery packs 100, 200, and 300. For example, the first battery pack 100 may include the battery management apparatus 10 that may obtain information about the plurality of battery packs 1000 and generate a control signal for controlling the plurality of battery packs 1000. The battery management apparatus 10 may perform communication (e.g., Controller Area Network communication) with a battery management apparatus (not shown) included in another battery pack.

In an embodiment, the battery management apparatus 10 may identify a state of each of the plurality of battery packs 1000. For example, the battery management apparatus 10 may identify a battery module voltage value and a voltage value of an output terminal of each of the plurality of battery packs 1000. The battery management apparatus 10 may directly measure a state of each of the plurality of battery packs 1000 and obtain information about a state of each of the plurality of battery packs 1000 from another battery management apparatus (not shown) included in each of the plurality of battery packs 1000.

The plurality of battery packs 1000 may include the plurality of battery packs 100, 200, and 300. For example, the battery packs 100, 200, and 300 may be connected in series. In this case, each of the battery packs 100, 200, and 300 may include a freewheeling diode.

While it is shown in FIG. 1 that the plurality of battery packs 1000 include the three battery packs 100, 200, and 300, the present invention is not limited thereto. That is, the plurality of battery packs 1000 may include n battery packs (n is a natural number greater than or equal to 2), and the battery management apparatus 10 may identify states of the n battery packs and generate control signals for controlling the n battery packs.

The battery management apparatus 10 according to embodiments disclosed herein may monitor states of the plurality of battery packs 1000 and generate control signals for controlling the plurality of battery packs 1000 to efficiently perform charging and discharging.

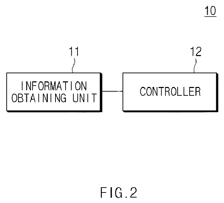

FIG. 2 is a block diagram of a battery management apparatus according to an embodiment disclosed herein.

Referring to FIG. 2, the battery management apparatus 10 according to the invention includes an information obtaining unit 11 and a controller 12. The battery management apparatus 10 may be substantially the same as the battery management apparatus 10 of FIG. 1. That is, the battery management apparatus 10 may identify the states of the plurality of battery packs 1000 of FIG. 1 and generate control signals for controlling the plurality of battery packs 1000. Hereinbelow, referring to FIGS. 1 and 2, the battery management apparatus 10 will be described.

The information obtaining unit 11 obtains a first voltage measured in an output terminal of each of a plurality of battery packs connected in series. For example, the information obtaining unit 11 may obtain a voltage value measured in an output terminal of each of the plurality of battery packs 1000 from an individual battery management apparatus (not shown) included in each of the plurality of battery packs 1000. In another example, the battery management apparatus 10 may directly measure a voltage value of an output terminal of each of the plurality of battery packs 1000, and the information obtaining unit 11 may obtain the measured voltage value.

The information obtaining unit 11 obtains a first voltage measured in an output terminal of each of a plurality of battery packs connected in series. For example, the information obtaining unit 11 may obtain a voltage value measured in an output terminal of each of the plurality of battery packs 1000 from an individual battery management apparatus (not shown) included in each of the plurality of battery packs 1000. In another example, the battery management apparatus 10 may directly measure a voltage value of an output terminal of each of the plurality of battery packs 1000, and the information obtaining unit 11 may obtain the measured voltage value.

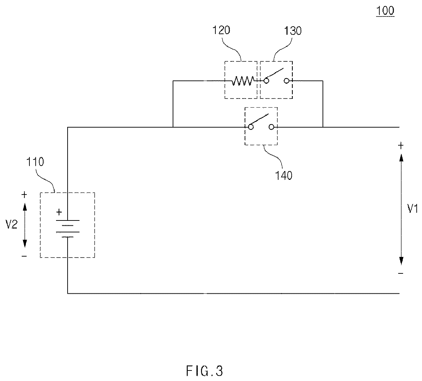

FIG. 3 illustrates a battery pack according to an embodiment disclosed herein.

Referring to FIG. 3, the battery pack 100 (e.g., the first battery pack 100 of FIG. 1) according to an embodiment disclosed herein may include a battery module 110, a precharge resistor 120, a precharge relay 130, and a main relay 140. In an embodiment, the battery pack 100 may be included in the plurality of battery packs 1000 of FIG. 1. That is, the battery packs 100, 200, and 300 of FIG. 1 may be substantially the same as the battery pack 100 of FIG. 3.
the battery management apparatus 10 obtains a voltage value V1 measured in an output terminal of the battery pack 100. For example, the battery management apparatus 10 may directly measure the voltage value of the output terminal of the battery pack 100, and another battery management apparatus (not shown) may be included in the battery pack 100 such that the battery management apparatus 10 may obtain a voltage value of the output terminal of the battery pack 100, measured by the other battery management apparatus (not shown) included in the battery pack 100.

The battery management apparatus 10 obtains a voltage value V2 of the battery module 110 of the battery pack 100. For example, the battery management apparatus 10 may directly measure the voltage value V2 of the battery module 110, and another battery management apparatus (not shown) may be included in the battery pack 100 such that the battery management apparatus 10 may obtain the voltage value V2 of the battery module 110, measured by the other battery management apparatus (not shown) included in the battery pack 100.

In an embodiment, the battery pack 100 may include the plurality of battery modules 110. For example, the battery pack 100 may include the plurality of battery modules 310, and the battery management apparatus 10 may obtain the voltage value V2 of the plurality of battery modules 310 connected in series. According to an embodiment, the battery pack 100 may include n battery modules 110 (n is a natural number greater than or equal to 1).

The precharge resistor 120 may be a resistor for limiting a speed of charging or discharging to balance a voltage with an external device (at least any one of an inverter, a converter, or a capacitor) in charging or discharging of the battery pack 100. For example, the precharge resistor 120 may reduce current flowing through the battery pack 100 in charging or discharging, by making a load inside the battery pack 100. In another example, the precharge resistor 120 may be serially connected to the precharge relay 130.

The precharge relay 130 and the main relay 140 may form charging and discharging paths of the battery pack 100. For example, the battery pack 100 may short-circuit the precharge relay 130 and open the main relay 140 in a precharge phase, and open the precharge relay 130 and short-circuit the main relay 140 in a main charge phase. In another example, the battery pack 100 may open both the precharge relay 130 and the main relay 140 when the battery pack 100 is not used. In an embodiment, operations of the precharge relay 130 and the main relay 140 may be controlled by a control signal delivered from the battery management apparatus 10 of FIG. 2.

In an embodiment, the precharge relay 130 and the main relay 140 may include any one of a bipolar junction transistor (BJT) or a metal-oxide-semiconductor field-effect transistor (MOSFET).

Referring back to FIG. 2, the controller 12 generates a control signal for controlling operations of a precharge relay and a main relay included in each of the plurality of battery packs 1000, based on a first voltage measured in an output terminal of each of the plurality of battery packs 1000 and a second voltage that is a battery module voltage value (a second voltage of a battery module of each of the plurality of battery packs 1000), in which the first voltage and the second voltage are obtained from the information obtaining unit 11. For example, when the plurality of battery packs 1000 do not operate, the controller 12 may generate a control signal for opening both the precharge relay and the main relay included in each of the plurality of battery packs 1000.

When operations of the plurality of battery packs 1000 connected in series are initiated, the controller 12 may generate a control signal for short-circuiting the precharge relay included in each of the plurality of battery packs 1000 and opening the main relay included in each of the plurality of battery packs. For example, when charging or discharging operations of the plurality of battery packs 1000 are initiated, the controller 12 may generate a control signal for short-circuiting the precharge relay included in each of the plurality of battery packs 1000 and opening the main relay included in each of the plurality of battery packs, and the plurality of battery packs 1000 may perform the precharge phase.

The controller 12 calculates a first result value by summing the first voltage of each of the plurality of battery packs 1000. For example, the controller 12 may calculate a voltage value measured in an output terminal of the whole plurality of battery packs 1000 connected in series by summing the first voltage of each of the plurality of battery packs 1000. That is, the first result value may be the voltage value measured in the output terminal of the whole plurality of battery packs 1000 connected in series.

The controller 12 compares a minimum value among second values of the plurality of battery packs 1000 with the first result value. For example, the controller 12 may find the minimum value by comparing battery module voltage values of the respective plurality of battery packs 1000, and compare the found minimum value with the first result value.

When the first result value is greater than the minimum value among the second voltages, the controller 12 generates a control signal for opening the precharge relay included in a battery pack having the second voltage corresponding to the minimum value and short-circuiting the main relay. For example, the controller 12 generates a control signal for opening the precharge relay included in the battery pack having the second voltage corresponding to the minimum value among the second voltages of the plurality of battery packs 1000 and short-circuiting the main relay and transmit the control signal to the battery pack having the second voltage corresponding to the minimum value, and the battery pack having the second voltage corresponding to the minimum value may perform charging or discharging without passing through a precharge resistor by opening the precharge relay and short-circuiting the main relay. That is, a precharge resistance of the whole plurality of battery packs 1000 may decrease.

In an embodiment, since the precharge relay of each of the plurality of battery packs 1000 is short-circuited and the main relay is opened when the plurality of battery packs 1000 are used first, precharge resistors of the plurality of battery packs 1000 are connected in series and thus the precharge resistance value of the whole precharge resistors is large, such that the controller 12 may reduce the precharge resistance value by generating a control signal for opening a precharge relay of one of the plurality of battery packs 1000 and short-circuiting a main relay of the battery pack 1000 in the above-described process.

The controller 12 may calculate a second result value by summing the second voltages of the battery packs including the short-circuited main relays among the plurality of battery packs 1000. The controller 12 may find the minimum value among the second voltages of battery packs 1000 including the short-circuited precharge relays and calculate a third result value by summing the minimum value and the second result value.

The controller 12 may compare the first result value with the third result value, and when the first result value is greater than the third result value, the controller 12 may generate a control signal for opening the precharge relay included in the battery pack having the second voltage corresponding to the minimum value among the second voltages of the battery packs including the short-circuited precharge relays and short-circuiting the main relay. For example, the controller 12 may compare the voltage value of the output terminal of the whole plurality of battery packs 1000 with the third result value, and when the voltage value of the output terminal of the whole plurality of battery packs 1000 is greater than the third result value, the controller 12 may generate a control signal for opening the precharge relay included in the battery pack having the second voltage corresponding to the minimum value among the second voltages of the battery packs including the short-circuited precharge relays and short-circuiting the main relay, thereby reducing the precharge resistance value of the whole plurality of battery packs 1000.

In an embodiment, the controller 12 may generate a control signal for opening a precharge relay of a battery pack corresponding to the minimum value among second voltages of battery packs including short-circuited precharge relays among the plurality of battery packs 1000 and short-circuiting a main relay in the above-described process, thereby sequentially reducing the precharge resistance value of the whole plurality of battery packs 1000.

The controller 12 may calculate a fourth result value by summing the second voltages of the plurality of battery packs 1000. When a difference between the calculated fourth result value and the first result value is less than or equal to a reference value, the controller 12 may generate a control signal for opening the precharge relays of the plurality of battery packs 1000 and short-circuiting the main relays. For example, the controller 12 may calculate the fourth result value by summing the battery module voltage values of the respective plurality of battery packs 1000, calculate the first result value by summing the voltage values of the output terminals of the respective plurality of battery packs 1000, compare the fourth result value with the first result value, and generate a control signal for opening the precharge relays of the whole plurality of battery packs 1000 connected in series and short-circuiting the main relays when a difference between the fourth result value and the first result value is less than or equal to a reference value (a threshold value or a set value), thereby completing the precharge phase and going to the main charge phase.

In an embodiment, the controller 12 may compare a voltage value applied to an external device (at least any one of a capacitor, an inverter, or a converter) connected to the plurality of battery packs 1000 with battery module voltage values of the whole plurality of battery packs 1000 and may generate a control signal for opening the precharge relays of the whole plurality of battery packs 1000 and short-circuiting the main relays because the plurality of battery packs 1000 may not be damaged in spite of short-circuiting of the main relays when a difference between the applied voltage value and the battery module voltage values is less than or equal to the reference value.

The battery management apparatus 10 according to an embodiment disclosed herein may generate a control signal for controlling operations of a precharge relay and a main relay included in each of the plurality of battery packs 1000, based on a voltage value measured in the output terminal of each of the plurality of battery packs 1000 and a battery module voltage value of each of the plurality of battery packs 1000. Thus, the battery management apparatus 10 may sequentially reduce the number of battery packs in which precharge relays are short-circuited and main relays are opened, thus sequentially reducing the precharge resistance value of the whole plurality of battery packs 1000 and reducing a precharge time of the plurality of battery packs 1000.

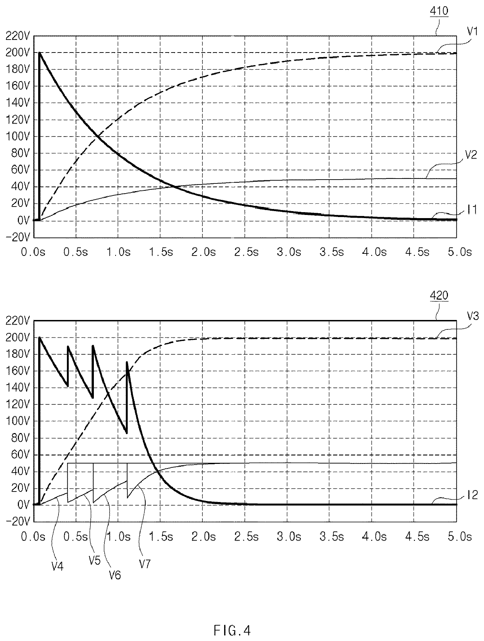

FIG. 4 shows a precharge time of a plurality of battery packs according to an embodiment disclosed herein.

Referring to FIG. 4, when a first graph 410 that is a graph regarding a precharge time of an existing plurality of battery packs connected in series is compared with a second graph 420 that is a graph regarding a precharge time of a plurality of serially connected battery packs controlled by the battery management apparatus 10, it may be seen that slopes at which the voltage value V1 and V3 of the output terminal of the whole plurality of battery packs increase are steeper for the battery management apparatus 10 in the second graph 420. It may be seen in the first graph 410 that the voltage V2 of the output terminal of each of the plurality of battery packs is the same until the precharge phase ends because the plurality of battery packs are connected in series, and it may be seen in the second graph 420 that voltages V3, V4, V5, and V6 of the output terminals of the plurality of battery packs have different values because the battery management apparatus 10 generates a control signal for opening the precharge relay and the main relay when the plurality of battery packs satisfy a predetermined condition, such that a time for completing the precharge phase in the second graph 420 is shorter than a time for completing the precharge phase in the first graph 410. Moreover, an output current I2 in the second graph 420 is higher than an output current I1 in the first graph 410, such that a time in which the precharge phase is completed may be regarded as being shorter in the second graph 420 than in the first graph 410.

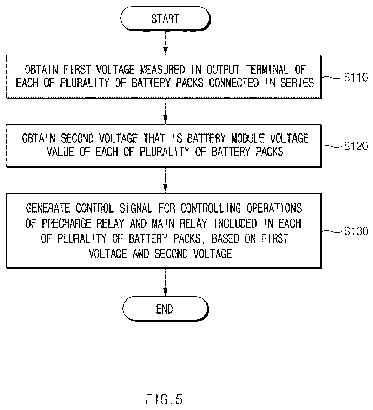

FIG. 5 is a flowchart of an operating method of a battery management apparatus according to an embodiment disclosed herein.

Referring to FIG. 5, an operating method of the battery management apparatus 10 according to an embodiment disclosed herein may include operation S110 of obtaining a first voltage measured in an output terminal of each of a plurality of battery packs connected in series, operation S120 of obtaining a second voltage that is a battery module voltage value of each of the plurality of battery packs, and operation S130 of generating a control signal for controlling operations of a precharge relay and a main relay included in each of the plurality of battery packs based on the first voltage and the second voltage.

In operation S110 of obtaining the first voltage measured in the output terminal of each of the plurality of serially connected battery packs, the information obtaining unit 11 may obtain a voltage of the output terminal of each of the plurality of serially connected battery packs. For example, the information obtaining unit 11 may obtain the first voltage by directly measuring a voltage value of the output terminal of each of the plurality of battery packs. In another example, the information obtaining unit 11 may obtain the first voltage that is the voltage value of each terminal of each of the plurality of battery packs from each battery management apparatus included in the plurality of battery packs.

In operation S120 of obtaining the second voltage that is a battery module voltage value of each of the plurality of battery packs, the information obtaining unit 11 may obtain the battery module voltage value of each of the plurality of battery packs. For example, the information obtaining unit 11 may obtain the battery module voltage value of each of the plurality of battery packs from each battery management apparatus included in the plurality of battery packs. In another example, the information obtaining unit 11 may directly measure a battery module voltage value of each of the plurality of battery packs. In an embodiment, each of the plurality of battery packs may include a plurality of battery modules, and thus a battery module voltage value of each of the plurality of battery packs may be a voltage value of a plurality of serially connected battery modules.

In operation S130 of generating a control signal for controlling operations of the precharge relay and the main relay included in each of the plurality of battery packs based on the first voltage and the second voltage, the controller 12 may generate a control signal for controlling the operations of the precharge relay and the main relay included in each of the plurality of battery packs based on the first voltage and the second voltage obtained in the information obtaining unit 11. For example, the precharge relay may be a relay connected to a precharge resistor, and when the precharge relay is short-circuited and the main relay is opened, an internal resistance may increase due to the precharge resistance and in contrast, when the precharge relay is opened and the main relay is short-circuited, the internal resistance may decrease. That is, the controller 12 may adjust a precharge resistance value of the whole plurality of battery packs by generating a control signal for controlling a precharge relay and a main relay included in each of the plurality of battery packs.

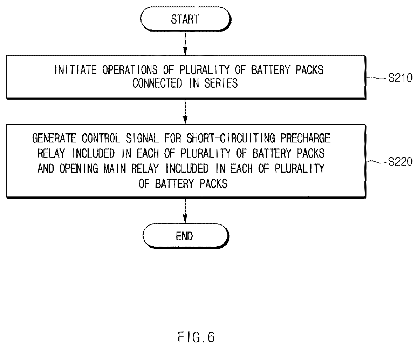

FIG. 6 is a flowchart of operations further included in an operating method of a battery management apparatus according to an embodiment disclosed herein.

Referring to FIG. 6, an operating method of the battery management apparatus 10 according to an embodiment disclosed herein may further include operation S210 of initiating operations of a plurality of serially connected battery packs and operation S220 of generating a control signal for short-circuiting a precharge relay included in each of the plurality of battery packs and opening a main relay included in each of the plurality of battery packs.

In operation S210 of initiating the operations of the plurality of serially connected battery packs, the controller 12 may identify a state in which the operations of the plurality of serially connected battery packs are initiated. For example, before the operation of each of the plurality of battery packs is initiated, both the precharge relay and the main relay may be in an open state. In another example, the controller 12 may determine whether the plurality of battery packs are in a charged state or a discharged state.

In operation S220 of generating the control signal for short-circuiting the precharge relay included in each of the plurality of battery packs and opening the main relay included in each of the plurality of battery packs, the controller 12 may generate the control signal for short-circuiting the precharge relay included in each of the plurality of battery packs and opening the main relay included in each of the plurality of battery packs when the operations of the plurality of battery packs are initiated. For example, when all of the main relays are short-circuited from the beginning, external devices (e.g., a capacitor, an inverter, and a converter) connected to the plurality of battery packs may have a large voltage difference than the battery module voltages of the whole plurality of battery packs and a high current may flow, resulting in a damage. That is, the controller 12 may balance a voltage value applied to an external device with a battery module voltage value by first short-circuiting the precharge relay of each of the plurality of battery packs, so as to prevent a damage of the plurality of battery packs or the external device.

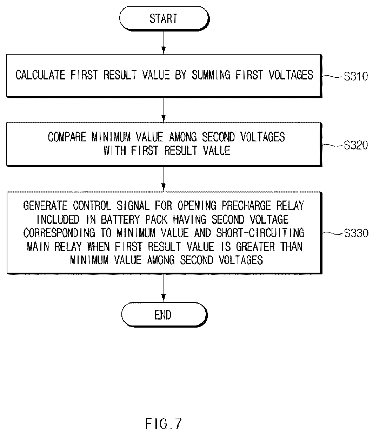

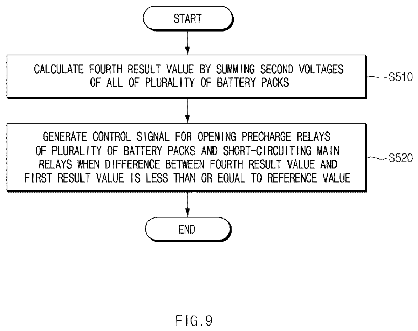

FIGS. 7 and 9 are flowcharts showing in detail operation S130 in an operating method of a battery management apparatus according to an embodiment disclosed herein.

Referring to FIG. 7, in the operating method of the battery management apparatus 10 according to an embodiment disclosed herein, operation S130 may include operation S310 of calculating a first result value by summing a first voltage, operation S320 of comparing a minimum value among second voltages with the first result value, and operation S330 of generating a control signal for opening a precharge relay included in a battery pack, which has a second voltage corresponding to the minimum value, and short-circuiting a main relay, when the first result value is greater than the minimum value among the second voltages.

In operation S310 of calculating the first result value by summing the first voltage, the controller 12 may calculate the first result value by summing the first voltage that is a voltage in an output terminal of each of the plurality of battery packs. For example, the first result value may be a voltage value in the output terminal of the whole plurality of battery packs. In another example, the first result value may be a voltage value applied to an external device connected to the plurality of battery packs.

In operation S320 of comparing the minimum value among the second voltages with the first result value, the controller 12 may find the minimum value by comparing the second voltages that are battery module voltage values of the respective plurality of battery packs, and compare the minimum value with the first result value.

In operation S330 of generating the control signal for opening a precharge relay included in a battery pack having a second voltage corresponding to the minimum value and short-circuiting a main relay when the first result value is greater than the minimum value among the second voltages, the controller 12 may generate a control signal for opening the precharge relay included in the battery pack having the second voltage corresponding to the minimum value and short-circuiting the main relay. For example, the controller 12 may reduce a precharge resistance of all of the plurality of battery packs by generating the control signal for opening the precharge relay included in the battery pack having the second voltage corresponding to the minimum value and short-circuiting the main relay, and reduce a time required for performing the precharge phase by reducing the precharge resistance.

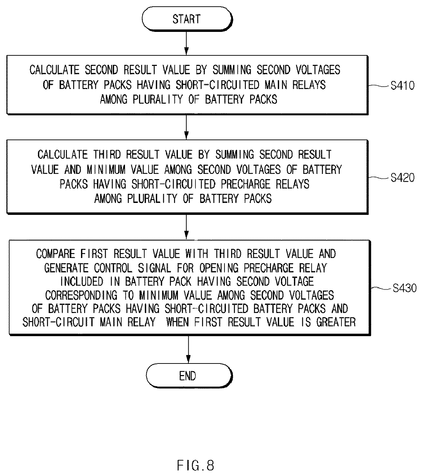

Referring to FIG. 8, in the operating method of the battery management apparatus 10 according to an embodiment disclosed herein, operation S130 may further include operation S410 of calculating a second result value by summing second voltages of battery packs having short-circuited main relays among the plurality of battery packs, operation S420 of calculating a third result value by summing the second result value and the minimum value among second voltages of battery packs having short-circuited precharge relays, and operation S430 of comparing the first result value with the third result value and generating a control signal for opening a precharge relay included in a battery pack having the second voltage corresponding to the minimum value among the second voltages of the battery packs having the short-circuited precharge relays and short-circuiting a main relay when the first result value is greater.

In operation S410 of calculating the second result value by summing the second voltages of the battery packs having the short-circuited main relays among the plurality of battery packs, the controller 12 may calculate the second result value by summing the second voltages that are battery module voltages of the battery pack having the short-circuited main relays among the plurality of battery packs.

In operation S420 of calculating the third result value by summing the second result value and the minimum value among the second voltages of the battery packs having the short-circuited precharge relays among the plurality of battery packs, the controller 12 may find the minimum value by comparing the second voltages of the battery packs having the short-circuited precharge relays among the plurality of battery packs and calculate the third result value by summing the minimum value and the second result value.

In operation S430 of comparing the first result value with the third result value and generating the control signal for opening a precharge relay included in a battery pack having a second voltage corresponding to the minimum value among the second voltages of the battery packs having the short-circuited precharge relays and short-circuiting a main relay when the first result value is greater, the controller 12 may compare the first result value calculated in operation S310 with the third result value and generate the control signal for opening the precharge relay included in the battery pack having the second voltage corresponding to the minimum value among the second voltages of the battery packs having the short-circuited precharge relays and short-circuiting the main relay when the first result value is greater. That is, the controller 12 may periodically compare the first result value with the third result value and generate the control signal for opening a precharge relay of one of battery packs having short-circuited precharge relays and short-circuiting a main relay at a point in time when the first result value is greater, thereby reducing a precharge resistance of the whole plurality of battery packs.

Referring to FIG. 9, in the operating method of the battery management apparatus 10 according to an embodiment disclosed herein, operation S130 may further include operation S510 of calculating a fourth result value by summing the second voltages of the plurality of battery packs and operation S520 of generating a control signal for opening precharge relays of the plurality of battery packs and short-circuiting main relays when a difference between the fourth result value and the first result value is less than or equal to a reference value.

In operation S510 of calculating the fourth result value by summing all of the second voltages of the plurality of battery packs, the controller 12 may calculate the fourth result value by summing all of the second voltages that are battery module voltage values of the respective plurality of battery packs. For example, the fourth result value may be a battery module voltage value of the whole plurality of battery packs.

In operation S520 of generating the control signal for opening the precharge relays of the plurality of battery packs and short-circuiting the main relays when the difference between the fourth result value and the first result value is less than or equal to the reference value, the controller 12 may calculate the difference between the fourth result value and the first result value calculated in operation S310, and generate the control signal for opening the precharge packs of the whole plurality of battery packs and short-circuiting the main relays when the difference is less than or equal to the reference value. For example, in case that the difference between the fourth result value and the first result value is less than or equal to the reference value, a battery pack or an external device may not be damaged even when the precharge relays of the whole plurality of battery packs are opened and the main relays are short-circuited, such that the controller 12 may generate the control signal for opening the precharge relays of the whole plurality of battery packs and short-circuiting the main relays when the difference between the fourth result value and the first result value is less than or equal to the reference value (a threshold value or a set value).

The operating method of the battery management apparatus 10 disclosed herein may sequentially reduce the number of battery packs having short-circuited precharge relays and opened main relays among the plurality of battery packs by performing the operations of FIGS. 7 to 9, and generate the control signal for opening the precharge relays of the whole plurality of battery packs and short-circuiting the main relays by performing operation S520 last, thereby terminating the precharge phase. That is, the operating method of the battery management apparatus 10 may reduce a precharge time of the plurality of battery packs connected in series by sequentially increasing the number of battery packs having short-circuited main relays.

The above description is merely illustrative of the technical idea of the present disclosure, and various modifications and variations will be possible without departing from the essential characteristics of the appended claims.

The protection scope of the invention is solely defined by the appended claims.

## Claims

1. A battery management apparatus (10) **characterized in that** the battery management device comprises :
an information obtaining unit (11) configured to obtain, for each of a plurality of battery packs connected in series, a first voltage measured in an output terminal of the corresponding battery pack, each battery pack comprises respectively at least one battery module connected in series to a main relay and a precharge relay connected serially to a precharge resistor, the main relay connected in parallel to the series connected precharge relay and precharge resistor, and the information obtaining unit (11) being further configured to obtain a second voltage that is a battery module voltage value of the at least one battery module of each of the plurality of battery packs; and
a controller (12) configured to generate a control signal for controlling operations of the precharge relay and the main relay included in each of the plurality of battery packs, based on the first voltage and the second voltage,
wherein the controller is further configured to:
calculate a first result value by summing first voltages;
compare a minimum value among second voltages with the first result value; and
generate a control signal for opening the precharge relay from short-circuiting, said precharge relay being included in the battery pack having the second voltage corresponding to the minimum value, and for short-circuiting the main relay from opening, when the first result value is greater than the minimum value among the second voltages during charging or discharging operations of the plurality of the battery packs.

2. The battery management apparatus of claim 1, wherein the controller is further configured to generate a control signal for short-circuiting the precharge relay included in each of the plurality of battery packs and opening the main relay included in each of the plurality of battery packs when charging or discharging operations of the plurality of battery packs connected in series are initiated.

3. The battery management apparatus of claim 1, wherein the controller is further configured to:
calculate a second result value by summing second voltages of battery packs comprising short-circuited main relays among the plurality of battery packs;
calculate a third result value by summing the second result value and a minimum value among second voltages of battery packs comprising short-circuited precharge relays among the plurality of battery packs; and
compare the first result value with the third result value, and generate the control signal for opening the precharge relay included in the battery pack having the second voltage corresponding to the minimum value among the second voltages of the battery packs including the short-circuited precharge relays and for short-circuiting the main relay from opening when the first result value is greater than the third result value.

4. The battery management apparatus of claim 1, wherein the controller is further configured to:
calculate a fourth result value by summing all of second voltages of the plurality of battery packs; and
generate a control signal for opening precharge relays of the plurality of battery packs from short-circuiting and for short-circuiting main relays from opening, when a difference between the fourth result value and the first result value is less than or equal to a reference value.

5. The battery management apparatus of claim 1, wherein the main relay and the precharge relay comprise any one of a bipolar junction transistor (BJT) or a metal-oxide-semiconductor field-effect transistor (MOSFET).

6. The battery management apparatus of claim 1, wherein each of the plurality of battery packs comprises a plurality of battery modules connected in series and the obtaining information unit is configured to obtain the second voltage of the plurality of the battery modules (310) connected in series.

7. An operating method of a battery management apparatus, **characterized in that** the operating method comprises:
Obtaining (S110), for each of a plurality of battery packs connected in series, a first voltage measured in an output terminal of the corresponding battery pack, each pack comprises respectively at least one battery module connected in series to a main relay and a precharge relay connected serially to a precharge resistor, the main relay connected in parallel to the series connected precharge relay and precharge resistor,
obtaining a second voltage (S120) that is a battery module voltage value of the at least one battery module of each of the plurality of battery packs; and
generating (S130) a control signal for controlling operations of a precharge relay and a main relay included in each of the plurality of battery packs, based on the first voltage and the second voltage,
wherein the generating of the control signal for controlling the operations of the precharge relay and the main relay included in each of the plurality of battery packs, based on the first voltage and the second voltage, comprises:
calculating a first result value by summing first voltages;
comparing a minimum value among second voltages with the first result value; and
generating a control signal for opening the precharge relay from short-circuiting, said precharge relay being included in the battery pack having the second voltage corresponding to the minimum value , and for short-circuiting the main relay from opening, when the first result value is greater than the minimum value among the second voltages during charging or discharging operations of the plurality of the battery packs.

8. The operating method of claim 7, further comprising:
Initiating charging or discharging operations of the plurality of battery packs connected in series; and
generating a control signal for short-circuiting the precharge relay included in each of the plurality of battery packs and opening the main relay included in each of the plurality of battery packs .

9. The operating method of claim 7, wherein the generating of the control signal for controlling the operations of the precharge relay and the main relay included in each of the plurality of battery packs, based on the first voltage and the second voltage, comprises:
calculating a second result value by summing second voltages of battery packs comprising short-circuited main relays among the plurality of battery packs;
calculating a third result value by summing the second result value and a minimum value among second voltages of battery packs comprising short-circuited precharge relays among the plurality of battery packs; and
comparing the first result value with the third result value, and generate the control signal for opening the precharge relay included in the battery pack having the second voltage corresponding to the minimum value among the second voltages of the battery packs including the short-circuited precharge relays and for short-circuiting the main relay from opening when the first result value is greater than the third result value.

10. The operating method of claim 7, wherein the generating of the control signal for controlling the operations of the precharge relay and the main relay included in each of the plurality of battery packs, based on the first voltage and the second voltage, comprises:
calculating a fourth result value by summing all of second voltages of the plurality of battery packs; and
generating a control signal for opening precharge relays of the plurality of battery packs from short-circuiting and for short-circuiting main relays from opening, when a difference between the fourth result value and the first result value is less than or equal to a reference value.

## Patentansprüche

1. Batterieverwaltungsvorrichtung (10), **dadurch gekennzeichnet, dass** die Batterieverwaltungsvorrichtung umfasst:
eine Informationenerhaltungseinheit (11), welche dazu eingerichtet ist, für jeden einer Mehrzahl von Batteriepacks, welche in Reihe geschaltet sind, eine erste Spannung zu erhalten, welche an einem Ausgangsanschluss des entsprechenden Batteriepacks gemessen ist, wobei jeder Batteriepack jeweils wenigstens ein Batteriemodul umfasst, welches mit einem Hauptrelais und einem Vorladerelais in Reihe geschaltet ist, welches seriell mit einem Vorladewiderstand geschaltet ist, wobei das Hauptrelais mit dem in Reihe geschalteten Vorladerelais und Vorladewiderstand parallel geschaltet ist,
und wobei die Informationenerhaltungseinheit (11) ferner dazu eingerichtet ist, eine zweite Spannung zu erhalten, welche ein Batteriemodul-Spannungswert des wenigstens einen Batteriemoduls von jedem der Mehrzahl von Batteriepacks darstellt; und
eine Steuereinheit (12), welche dazu eingerichtet ist, ein Steuerungssignal zum Steuern von Betrieben des Vorladerelais und des Hauptrelais zu erzeugen, welche in jedem der Mehrzahl von Batteriepacks umfasst sind, auf Grundlage der ersten Spannung und der zweiten Spannung,
wobei die Steuereinheit ferner eingerichtet ist, zum:
Berechnen eines ersten Ergebniswertes durch ein Summieren von ersten Spannungen;
Vergleichen eines minimalen Wertes unter zweiten Spannungen mit dem ersten Ergebniswert; und
Erzeugen eines Steuerungssignals zum Öffnen des Vorladerelais von einem Kurzschließen, wobei das Vorladerelais in dem Batteriepack umfasst ist, welcher die zweite Spannung aufweist, welche dem minimalen Wert entspricht, und zum Kurzschließen des Hauptrelais von einem Öffnen, wenn der erste Ergebniswert größer ist als der minimale Wert unter den zweiten Spannungen während Lade- oder Entladebetrieben der Mehrzahl von Batteriepacks.

2. Batterieverwaltungsvorrichtung nach Anspruch 1, wobei die Steuerungseinheit ferner eingerichtet ist, zum Erzeugen eines Steuerungssignals zum Kurzschließen des Vorladerelais, welches in jedem der Mehrzahl von Batteriepacks umfasst ist, und Öffnen des Hauptrelais, welches in jedem der Mehrzahl von Batteriepacks umfasst ist, wenn Lade- und Entladebetriebe der Mehrzahl von Batteriepacks initiiert sind, welche in Reihe geschaltet sind.

3. Batterieverwaltungsvorrichtung nach Anspruch 1, wobei die Steuerungseinheit ferner eingerichtet ist, zum:
Berechnen eines zweiten Ergebniswertes durch ein Summieren von zweiten Spannungen von Batteriepacks, welche kurzgeschlossene Hauptrelais unter der Mehrzahl von Batteriepacks umfassen;
Berechnen eines dritten Ergebniswertes durch ein Summieren des zweiten Ergebniswertes und eines minimalen Wertes unter zweiten Spannungen von Batteriepacks, welche kurzgeschlossene Vorladerelais unter der Mehrzahl von Batteriepacks umfassen; und
Vergleichen des ersten Ergebniswertes mit dem dritten Ergebniswert, und Erzeugen des Steuerungssignals zum Öffnen des Vorladerelais, welches in dem Batteriepack umfasst ist, welcher die zweite Spannung aufweist, welche dem minimalen Wert entspricht, unter den zweiten Spannungen der Batteriepacks, welche die kurzgeschlossenen Vorladerelais umfassen, und zum Kurzschließen des Hauptrelais von einem Öffnen, wenn der erste Ergebniswert größer ist als der dritte Ergebniswert.

4. Batterieverwaltungsvorrichtung nach Anspruch 1, wobei die Steuerungseinheit ferner eingerichtet ist, zum:
Berechnen eines vierten Ergebniswertes durch ein Summieren aller zweiter Spannungen der Mehrzahl von Batteriepacks; und
Erzeugen eines Steuerungssignals zum Öffnen von Vorladerelais der Mehrzahl von Batteriepacks von einem Kurzschließen und zum Kurzschließen von Hauptrelais von einem Öffnen, wenn eine Differenz zwischen dem vieren Ergebniswert und dem ersten Ergebniswert geringer als oder gleich wie ein Referenzwert ist.

5. Batterieverwaltungsvorrichtung nach Anspruch 1, wobei das Hauptrelais und das Vorladerelais einen aus einem Bipolartransistor (BJT) oder einem Metall-Oxid-Halbleiter-Feldeffekttransistor (MOSFET) umfassen.

6. Batterieverwaltungsvorrichtung nach Anspruch 1, wobei jeder der Mehrzahl von Batteriepacks eine Mehrzahl von Batteriemodulen umfasst, welche in Reihe geschaltet sind, und die Informationenerhaltungseinheit dazu eingerichtet ist, die zweite Spannung der Mehrzahl von Batteriemodulen (310) zu erhalten, welche in Reihe geschaltet sind.

7. Betriebsverfahren einer Batterieverwaltungsvorrichtung, **dadurch gekennzeichnet, dass** das Betriebsverfahren umfasst:
Erhalten (S110), für jeden einer Mehrzahl von Batteriepacks, welche in Reihe geschaltet sind, einer ersten Spannung, welche an einem Ausgangsanschluss des entsprechenden Batteriepacks gemessen wird, wobei jeder Batteriepack jeweils wenigstens ein Batteriemodul umfasst, welches mit einem Hauptrelais und einem Vorladerelais in Reihe geschaltet ist, welches seriell mit einem Vorladewiderstand geschaltet ist, wobei das Hauptrelais mit dem in Reihe geschalteten Vorladerelais und Vorladewiderstand parallel geschaltet ist,
Erhalten einer zweiten Spannung (S120), welche ein Batteriemodul-Spannungswert des wenigstens einen Batteriemoduls von jedem der Mehrzahl von Batteriepacks darstellt; und
Erzeugen (S130) eines Steuerungssignals zum Steuern von Betrieben eines Vorladerelais und eines Hauptrelais, welche in jedem der Mehrzahl von Batteriepacks umfasst sind, auf Grundlage der ersten Spannung und der zweiten Spannung,
wobei das Erzeugen des Steuerungssignals zum Steuern der Betriebe des Vorladerelais und des Hauptrelais, welche in jedem der Mehrzahl von Batteriepacks umfasst sind, auf Grundlage der ersten Spannung und der zweiten Spannung, umfasst:
Berechnen eines ersten Ergebniswertes durch ein Summieren von ersten Spannungen;
Vergleichen eines minimalen Wertes unter zweiten Spannungen mit dem ersten Ergebniswert; und
Erzeugen eines Steuerungssignals zum Öffnen des Vorladerelais von einem Kurzschließen, wobei das Vorladerelais in dem Batteriepack umfasst ist, welcher die zweite Spannung aufweist, welche dem minimalen Wert entspricht, und zum Kurzschließen des Hauptrelais von einem Öffnen, wenn der erste Ergebniswert größer ist als der minimale Wert unter den zweiten Spannungen während Lade- oder Entladebetrieben der Mehrzahl von Batteriepacks.

8. Betriebsverfahren nach Anspruch 7, ferner umfassend:
Initiieren von Lade- oder Entladebetrieben der Mehrzahl von Batteriepacks, welche in Reihe geschaltet sind; und
Erzeugen eines Steuerungssignals zum Kurzschließen des Vorladerelais, welches in jedem der Mehrzahl von Batteriepacks umfasst ist, und Öffnen des Hauptrelais, welches in jedem der Mehrzahl von Batteriepacks umfasst ist.

9. Betriebsverfahren nach Anspruch 7, wobei das Erzeugen des Steuerungssignals zum Steuern von Betrieben des Vorladerelais und des Hauptrelais, welche in jedem der Mehrzahl von Batteriepacks umfasst sind, auf Grundlage der ersten Spannung und der zweiten Spannung, umfasst:
Berechnen eines zweiten Ergebniswertes durch ein Summieren von zweiten Spannungen von Batteriepacks, welche kurzgeschlossene Hauptrelais unter der Mehrzahl von Batteriepacks umfassen;
Berechnen eines dritten Ergebniswertes durch ein Summieren des zweiten Ergebniswertes und eines minimalen Wertes unter zweiten Spannungen von Batteriepacks, welche kurzgeschlossene Hauptrelais unter der Mehrzahl von Batteriepacks umfassen; und
Vergleichen des ersten Ergebniswertes mit dem dritten Ergebniswert, und Erzeugen des Steuerungssignals zum Öffnen des Vorladerelais, welches in dem Batteriepack umfasst ist, welcher die zweite Spannung aufweist, welche dem minimalen Wert entspricht, unter den zweiten Spannungen der Batteriepacks, welche die kurzgeschlossenen Vorladerelais umfassen, und zum Kurzschließen des Hauptrelais von einem Öffnen, wenn der erste Ergebniswert größer ist als der dritte Ergebniswert.

10. Betriebsverfahren nach Anspruch 7, wobei das Erzeugen des Steuerungssignals zum Steuern von Betrieben des Vorladerelais und des Hauptrelais, welche in jedem der Mehrzahl von Batteriepacks umfasst sind, auf Grundlage der ersten Spannung und der zweiten Spannung, umfasst:
Berechnen eines vierten Ergebniswertes durch ein Summieren aller zweiter Spannungen der Mehrzahl von Batteriepacks; und
Erzeugen eines Steuerungssignals zum Öffnen von Vorladerelais der Mehrzahl von Batteriepacks von einem Kurzschließen und zum Kurzschließen von Hauptrelais von einem Öffnen, wenn eine Differenz zwischen dem vieren Ergebniswert und dem ersten Ergebniswert geringer als oder gleich wie ein Referenzwert ist.

## Revendications

1. Appareil de gestion de batterie (10) **caractérisé en ce que** le dispositif de gestion de batterie comprend :
une unité d'obtention d'informations (11) configurée pour obtenir, pour chacun d'une pluralité de blocs-batteries connectés en série, une première tension mesurée à une borne de sortie du bloc-batterie correspondant, chaque bloc-batterie comprenant respectivement au moins un module de batterie connecté en série à un relais principal et un relais de précharge connecté en série à une résistance de précharge, le relais principal étant connecté en parallèle au relais de précharge et à la résistance de précharge connectés en série, et l'unité d'obtention d'informations (11) étant en outre configurée pour obtenir une deuxième tension qui correspond à une valeur de tension de module de batterie de l'au moins un module de batterie de chacun de la pluralité de blocs-batteries ; et
un dispositif de commande (12) configuré pour générer un signal de commande afin de commander des opérations du relais de précharge et du relais principal inclus dans chacun de la pluralité de blocs-batteries, sur la base de la première tension et de la deuxième tension,
dans lequel le dispositif de commande est en outre configuré pour :
calculer une première valeur de résultat en additionnant de premières tensions ;
comparer une valeur minimale parmi les deuxièmes tensions à la première valeur de résultat ; et générer un signal de commande pour ouvrir le relais de précharge en cas de court-circuit, ledit relais de précharge étant inclus dans le bloc-batterie présentant la deuxième tension correspondant à la valeur minimale, et pour court-circuiter le relais principal en cas d'ouverture, lorsque la première valeur de résultat est supérieure à la valeur minimale parmi les deuxièmes tensions lors d'opérations de charge ou de décharge de la pluralité de blocs-batteries.

2. Appareil de gestion de batterie selon la revendication 1, dans lequel le dispositif de commande est en outre configuré pour générer un signal de commande pour court-circuiter le relais de précharge inclus dans chacun de la pluralité de blocs-batteries et ouvrir le relais principal inclus dans chacun de la pluralité de blocs-batteries lorsque des opérations de charge ou de décharge de la pluralité de blocs-batteries connectés en série sont initiées.

3. Appareil de gestion de batterie selon la revendication 1, dans lequel le dispositif de commande est en outre configuré pour :
calculer une deuxième valeur de résultat en additionnant de deuxièmes tensions de blocs-batteries comprenant des relais principaux court-circuités parmi la pluralité de blocs-batteries ;
calculer une troisième valeur de résultat en additionnant la deuxième valeur de résultat et une valeur minimale parmi les deuxièmes tensions de blocs-batteries comprenant des relais de précharge court-circuités parmi la pluralité de blocs-batteries ; et
comparer la première valeur de résultat à la troisième valeur de résultat, et générer le signal de commande pour ouvrir le relais de précharge inclus dans le bloc-batterie présentant la deuxième tension correspondant à la valeur minimale parmi les deuxièmes tensions des blocs-batteries comportant les relais de précharge court-circuités et pour court-circuiter le relais principal en cas d'ouverture lorsque la première valeur de résultat est supérieure à la troisième valeur de résultat.

4. Appareil de gestion de batterie selon la revendication 1, dans lequel le dispositif de commande est en outre configuré pour :
calculer une quatrième valeur de résultat en additionnant toutes les deuxièmes tensions de la pluralité de blocs-batteries ; et
générer un signal de commande pour ouvrir des relais de précharge de la pluralité de blocs-batteries en cas de court-circuit et pour court-circuiter des relais principaux en cas d'ouverture, lorsqu'une différence entre la quatrième valeur de résultat et la première valeur de résultat est inférieure ou égale à une valeur de référence.

5. Appareil de gestion de batterie selon la revendication 1, dans lequel le relais principal et le relais de précharge comprennent l'un ou l'autre parmi un transistor à jonction bipolaire (BJT) ou un transistor à effet de champ métal-oxyde semiconducteur (MOSFET).

6. Appareil de gestion de batterie selon la revendication 1, dans lequel chacun de la pluralité de blocs-batteries comprend une pluralité de modules de batterie connectés en série et l'unité d'obtention d'informations est configurée pour obtenir la deuxième tension de la pluralité de modules de batterie (310) connectés en série.

7. Procédé de fonctionnement d'un appareil de gestion de batterie, **caractérisé en ce que** le procédé de fonctionnement comprend :
l'obtention (S110), pour chacun d'une pluralité de blocs-batteries connectés en série, d'une première tension mesurée à une borne de sortie du bloc-batterie correspondant, chaque bloc comprenant respectivement au moins un module de batterie connecté en série à un relais principal et un relais de précharge connecté en série à une résistance de précharge, le relais principal étant connecté en parallèle au relais de précharge et à la résistance de précharge connectés en série,
l'obtention d'une deuxième tension (S120) qui est une valeur de tension de module de batterie de l'au moins un module de batterie de chacun de la pluralité de blocs-batteries ; et
la génération (S130) d'un signal de commande pour commander des opérations d'un relais de précharge et d'un relais principal inclus dans chacun de la pluralité de blocs-batteries, sur la base de la première tension et de la deuxième tension, dans lequel la génération du signal de commande pour commander les opérations du relais de précharge et du relais principal inclus dans chacun de la pluralité de blocs-batteries, sur la base de la première tension et de la deuxième tension, comprend :
le calcul d'une première valeur de résultat en additionnant de premières tensions ;
la comparaison d'une valeur minimale parmi les deuxièmes tensions à la première valeur de résultat ; et
la génération d'un signal de commande pour ouvrir le relais de précharge en cas de court-circuit,
ledit relais de précharge étant inclus dans le bloc-batterie présentant la deuxième tension correspondant à la valeur minimale, et pour court-circuiter le relais principal en cas d'ouverture, lorsque la première valeur de résultat est supérieure à la valeur minimale parmi les deuxièmes tensions lors d'opérations de charge ou de décharge de la pluralité de blocs-batteries.

8. Procédé de fonctionnement selon la revendication 7, comprenant en outre :
L'initiation d'opérations de charge ou de décharge de la pluralité de blocs-batteries connectés en série ; et
la génération d'un signal de commande pour court-circuiter le relais de précharge inclus dans chacun de la pluralité de blocs-batteries et ouvrir le relais principal inclus dans chacun de la pluralité de blocs-batteries.

9. Procédé de fonctionnement selon la revendication 7, dans lequel la génération du signal de commande pour commander les opérations du relais de précharge et du relais principal inclus dans chacun de la pluralité de blocs-batteries, sur la base de la première tension et de la deuxième tension, comprend :
le calcul d'une deuxième valeur de résultat en additionnant de deuxièmes tensions de blocs-batteries comprenant des relais principaux court-circuités parmi la pluralité de blocs-batteries ;
le calcul d'une troisième valeur de résultat en additionnant la deuxième valeur de résultat et une valeur minimale parmi les deuxièmes tensions de blocs-batteries comprenant des relais de précharge court-circuités parmi la pluralité de blocs-batteries ; et
la comparaison de la première valeur de résultat à la troisième valeur de résultat, et la génération du signal de commande pour ouvrir le relais de précharge inclus dans le bloc-batterie présentant la deuxième tension correspondant à la valeur minimale parmi les deuxièmes tensions des blocs-batteries comportant les relais de précharge court-circuités et pour court-circuiter le relais principal en cas d'ouverture lorsque la première valeur de résultat est supérieure à la troisième valeur de résultat.

10. Procédé de fonctionnement selon la revendication 7, dans lequel la génération du signal de commande pour commander les opérations du relais de précharge et du relais principal inclus dans chacun de la pluralité de blocs-batteries, sur la base de la première tension et de la deuxième tension, comprend :
le calcul d'une quatrième valeur de résultat en additionnant toutes les deuxièmes tensions de la pluralité de blocs-batteries ; et
la génération d'un signal de commande pour ouvrir des relais de précharge de la pluralité de blocs-batteries en cas de court-circuit et pour court-circuiter des relais principaux en cas d'ouverture, lorsqu'une différence entre la quatrième valeur de résultat et la première valeur de résultat est inférieure ou égale à une valeur de référence.
